# EUROPÄISCHE PATENTSCHRIFT

(11) **EP 1 861 783 B1**
(45) Veröffentlichungstag und Bekanntmachung des Hinweises auf die Patenterteilung: **25.03.2009**
(21) Anmeldenummer: 06724975.5
(22) Anmeldetag: 08.03.2006
(51) Int. Cl.: G06F 11/26

(54) **SYSTEM UND VERFAHREN ZUM TESTEN EINER STEUERGERÄTEANORDNUNG**
SYSTEM AND METHOD FOR TESTING A CONTROL APPARATUS ASSEMBLY
SYSTEME ET PROCEDE POUR TESTER UN ENSEMBLE D'APPAREIL(S) DE COMMANDE

(30) Priorität: 11.03.2005 DE 102005011246
(43) Veröffentlichungstag der Anmeldung: 05.12.2007
(73) Patentinhaber: ROBERT BOSCH GMBH, 70442 Stuttgart (DE)
(72) Erfinder: MAIER, Hermann, 71706 Markgroeningen (DE); SCHUBERT-HEIDT, Peter, 75449 Wurmberg (DE)
(86) Internationale Anmeldenummer: PCT/EP2006/060553
(87) Internationale Veröffentlichungsnummer: WO 2006/094992

(56) Entgegenhaltungen:
- DE-A1- 3 917 979
- US-A- 4 831 560
- "POWER THERMAL FUNCTION GENERATOR" IBM TECHNICAL DISCLOSURE BULLETIN, IBM CORP. NEW YORK, US, Bd. 33, Nr. 8, Januar 1991 (1991-01), Seiten 416-419, XP000109307 ISSN: 0018-8689

## Beschreibung

### Technisches Gebiet

Die Erfindung betrifft ein System sowie ein Verfahren zum Testen einer aus mindestens einem Steuergerät und mindestens einem Sensor bestehenden Steuergeräteanordnung, wobei Steuergerät und Sensor und etwaige weitere Busteilnehmer über einen Datenbus miteinander verbunden sind, und wobei zum Testen der Steuergeräteanordnung ein Testsignal in einen der Busteilnehmer eingespeist wird.

Derartige Systeme können insbesondere zum Testen von Fahrzeugsystemen eingesetzt werden. Fahrzeugsysteme wie ESP (Electronic Stabilitäts-Programm) zur Schlupfregelung, TCS (Traction Control System) zur Traktionsregelung, ABS (Antiblockiersystem) zur Bremsregelung bedienen sich solcher Steuergeräteanordnungen und werden zunehmend in modernen Kraftfahrzeugen eingesetzt. Mit Hilfe entsprechender Sensoren und aufwendiger Signalverarbeitung werden dem Fahrzeugsystem zugeordnete Faktoren über ein Steuergerät angesteuert.

### Stand der Technik

Aus der DE 197 11 734 C2 ist ein System zur Einspeisung von Simulationsdaten in Steuergeräte und zur Verarbeitung der Simulationsdaten bekannt. Am konkreten Beispiel eines Airbag-Steuergeräts schlägt die Lehre dieser Patentschrift vor, mittels eines einzigen Rechners sowohl die Einspeisung analoger Simulationssignale (Crash-Signale) als auch die Kommunikation mit dem Steuergerät und Steuerung des Steuergeräts vornehmen zu lassen. Der frühere für die Einspeisung der Simulationssignale verwendete separate Rechner sowie die damit verbundene eigens vorgenommene Konvertierung und Skalierung der Crash-Simulationsdaten kann somit entfallen (wegen bereits vorhandener Kompatibilität des einen Rechners). Die Signaleinspeisung des analogen Simulationssignals erfolgt dort, wo im Realfall das Signal des Beschleunigungssensors eingespeist wird. Die aufgrund der Simulation von der Steuereinheit erzeugten Signale, die im Normalbetrieb entsprechende Aktoren ansteuern, werden von demselben Rechner erfasst und ausgewertet.

Weiterhin ist aus der DE 101 11 266 C1 ein Verfahren zum Überprüfen eines Schnittstellenbausteins bekannt. Die Überprüfung wird hier von einem Prozessor durch Übertragung eines ersten Datentelegramms zu dem genannten Schnittstellenbaustein eingeleitet. Hierdurch wird der Schnittstellenbaustein in einen Testmodus versetzt und überträgt dann nicht mehr Sensordaten, die er im Normalbetrieb von einem Sensor erhält, sondern überträgt vielmehr aus Registern fest gespeicherte Testwerte an diesen Prozessor. Diese Testsensorwerte durchlaufen den zugehörigen Verarbeitungsprozess, woraufhin der Prozessor eine weitere Einheit, wie eine Zündkreisansteuerung, ansteuert. Die Zündkreisansteuerung ihrerseits wird daraufhin Aktoren, nämlich Rückhaltemittel ansteuern, ohne dass es im Testmodus zu einer Auslösung kömmt. Durch die hier vorgeschlagenen Testsensorwerte aus den Registern des Schnittstellenbausteins kann somit ein kompletter Test der Verarbeitung der Sensorwerte im Steuergerät durchgeführt werden.

Aus der DE 100 49 526 C2 und der DE 100 56 549 C2 ist die Mehrfachnutzung von Sensorsignalen durch mehrere Fahrzeugsysteme bekannt. Für die bereits eingangs genannten Fahrzeugsysteme werden äußere Einflüsse durch Sensoren am und im Fahrzeug erfasst, woraus auf die momentane Fahrsituation geschlossen werden kann. Jeder Regler einer Fahrzeugsystems erhält Sollwert-Vorgaben, z.B. vom Fahrer, und erzeugt seinerseits Ansteuersignale für Aktoren. In den genannten Schriften wird ein Schätzmodul vorgeschlagen, das äußere Stellgrößen über vorhandene Sensoren erfasst und als Regelgrößen Istwerte bildet, die allen betreffenden Reglern der Fahrzeugsystems zur Verfügung gestellt werden. Hierdurch kann die mehrfache Berechnung von fahrzeugrelevanten Größen in den einzelnen Fahrzeugsystemen entfallen.

Bereits seit einigen Jahren zeichnet es sich ab, dass eine analoge Signaleinspeisung, wie sie Gegenstand der erwähnten D E 197 11 734 C2 ist, zum Testen einer Steuergeräteänordnung an die Grenze ihrer Einsetzbarkeit anlangt. Eine Signaleinspeisung in immer komplexer und intelligenter werdende Sensoren wird trotz voranschreitender technischer Entwicklung risikoreicher. Dies ist zum einen in der Entwicklung selbst begründet, da immer mehr Schutzmechanismen und Regelkreise die Sensoren gegenüber Störungen und Fremdbeeinflussungen unempfindlicher machen. Hinzu kommt die Vorverlagerung der digitalen Signalverarbeitung an den physikalischen Signalaufnehmer, wie z.B. der integrierte Sigma/Delta-Wandler, der gleichzeitig den Signalaufnehmer (kapazitiver seismischer Kamm) anregt. Nicht zu vernachlässigen sind schließlich auch die Kosten, die für Test- und Stimuluseingänge in jedem Sensor im Feld mitgetragen werden müssen. Derartige zusätzliche Eingänge können jedoch gleichzeitig das Verhalten des Sensors negativ beeinflussen.

Die Druckschrift US 4 831 560 betrifft eine Diagnose-Prüfeinheit für die Elektroniksysteme eines Fahrzeugs, dessen Elektroniksysteme eine Steuerschaltung umfassen und durch sie gesteuert werden, wobei die Diagnose-Prüfeinheit einen Mikroprozessor, einen Sendeempfänger und ein Programmmittel umfasst. Dabei ist der Sendeempfänger derart anschließbar, um eine Schnittstelle zwischen dem Mikroprozessor und den Fahrzeug-Elektroniksystemen zu schaffen. Das Programmmittel speichert Informationen zur Verwendung beim Durchführen einer Diagnose-Prüfung der Elektroniksysteme, wobei der Mikroprozessor dazu ausgelegt ist, die Steuerung mindestens eines der Elektroniksysteme von der Steuerschaltung zu übernehmen.

Der Artikel "Power Thermal Function Generator" aus Vol. 33 Nr. 8 des IBM Technical Disclosure Bulletins beschreibt einen Generator zu Kontrolle einer Funktion einer Heizleistung in einem Großrechner und ist dazu ausgebildet, ein Modul zur Bereitstellung einer Heizleistung zu testen. Hierzu werden Sensoren für physikalische Parameter durch Ausgänge des Generators, die einer rechnergestützten Überprüfung unterliegen, entsetzt- Dabei werden Parameter wie Strom, Spannung und Temperatur durch den Generator überwacht

Eine Emulationsvorrichtung für ein wenigstens einen Mikroprozessor und einen Daten/Programm-Lesespeicher (EPROM od. dgl.) aufweisendes Steuergerät sind aus der Druckschrift DE 39 17 979 A1 bekannt. Hier ist eine Daten-Manipulationsvorrichtung vorgesehen, die einen Schreib-/Lesespeicher aufweist, wobei der Schreib-/Lesespeicher mit dem Mikroprozessor verbunden ist, und ein externes, an eine insbesondere serielle Schnittstelle des Steuergeräts anschließbares Bediengerät zur Veränderung von Daten des Schreib-/Lesespeichers vorgesehen ist. Die im Gehäuse des Steuergeräts ängeordnete Daten-Manipulationsvorrichtung weist eine Umschaltvorrichtung zur Umschaltung des Lesezugriffs auf den Schreib-/Lesespeicher oder den Daten/Programm-Lesespeicher auf, wobei der Schreib-/Lesespeicher über Busleitungen mit dem Mikroprozessor verbunden ist.

Aus den genannten Gründen ist die Eingangsgrößenverarbeitung durch analoge Seimulierung technisch immer schwerer zu realisieren und zudem nicht mehr kosten- und aufwandsneutral zu gewährleisten. Der Signalrauschabstand, Eigenrauschen, Störungseinflüsse, sowie Ungenauigkeiten behindern bei der technischen Realisation und gleichzeitig wird die Reproduktion des gewünschten Verhaltens immer schlechter.

Zusätzlich werden die Anforderungen an die Tests, beispielsweise von Fahrzeugsystemen, immer höher, da hohe Sicherheitsstandards, Kundenwünsche sowie immer komplexer werdende Systeme zu berücksichtigen sind. Es besteht demnach Bedarf an einem System und einem Verfahren zum Testen einer Steuergeräteanordnung mit mindestens einem Steuergerät und mindestens einem Sensor, insbesondere für Fahrzeugsysteme, die das Testen in technischer Hinsicht in vertretbar einfacher Weise bei hoher Zuverlässigkeit ermöglichen.

### Darstellung der Erfindung

Die Erfindung betrifft ein System zum Testen einer aus mindestens einem Steuergerät und mindestens einem Sensor bestehenden Steuergeräteanordnung, wobei Steuergerät und Sensor und etwaige weitere Busteilnehmer über einen Datenbus miteinander verbunden sind, und wobei zum Testen der Steuergeräteanordnung ein Testsignal in einen der Busteilnehmer eingespeist wird, wobei zumindest einer der Busteilnehmer durch einen entsprechenden Emulator dieses Busteünehmers ersetzt ist. Der Emulator besitzt unterschiedliche Verarbeitungsebenen. Eine für die Ankopplung des zu emulierenden Busteilnehmers an die Steuergeräteanordnung zuständige Verarbeitungsebene ist durch eine individuell nutzbare Verarbeitungsebene im Emulator ersetzt.

Durch das erfindungsgemäße Ersetzen eines Originalbusteilnehmers durch einen entsprechenden Emulator dieses Busteilnehmers im Testfall gelingt ein sichereres und genaueres Testen als durch die bisher bekannte Simulation dieses Busteilnehmers. Während bei einer Simulation allgemein Experimente an einem Modell der Realität vollzogen werden, um Erkenntnisse über die reale Situation zu gewinnen, wird bei einer Emulation das System selbst funktionell nachgebildet. Bei einer Simulation zählt in erster Linie das Ergebnis, während andere Aspekte, die für die zu beantwortende Fragestellung (vermutlich) nur eine geringe Rolle spielen, vereinfacht oder ganz weggelassen werden. Bei der Emulation hingegen erhält das nachgebildete System die gleichen Daten, es führt die gleichen Programme aus und erzielt die gleichen Ergebnisse wie das nachgebildete System. Der Emulator, also das System, das ein anderes emuliert, kann mit Vorteil mit dem aus der Factory vorhandenen Originalcode betrieben werden, die gleichen Anregungen wie das nachgebildete System erhalten und je nach Aufbau zusätzliche Optionen beinhalten. Die wichtigsten Funktionen des originalen Busteilnehmers werden durch den Emulator real nachgestellt. Somit ist die Emulation nicht nur sicherer und genauer als die Simulation, der erfindungsgemäße Emulator ist sogar leistungsfähiger, stabiler und flexibler als der Originalteilnehmer.

Es ist vorteilhaft, wenn derjenige Busteilnehmer, in den das Testsignal einzuspeisen ist, durch seinen entsprechenden Emulator ersetzt wird. Hier ist es insbesondere sinnvoll, einen Emulator eines Sensors zum Testen einer Steuergeräteanordnung einzusetzen. Im folgenden soll die Erfindung zur besseren Veranschaulichung anhand eines Serisor-Emulators erläutert werden, wobei ohne Einschränkung der Allgemeinheit dieser Sensoremulator stellvertretend für ein Modul/Bauteil einer Steuergeräteanordnung stehen soll, also allgemein für einen Busteilnehmer einer solchen über einen Datenbus kommunizierenden Steuergeräteanordnung.

Betrachtet man einen solchen Sensor im genannten Sinne, sind die folgenden Einheiten relevant:
1. die physikalische Busankopplung/Busart,
2. die Protokollerzeugung,
3. die Ausgangsgrößenverarbeitung,
4. die Logik/Steuerung sowie
5. die Eingangsgrößenverarbeitung.

Die Emulation der Logik/Steuerung, Ausgangsgrößenverarbeitung und Protokollerzeugung kann von dem originalen Busteilnehmer übernommen werden, wobei diese Übernahme auf der Portierung der beispielsweise VHDL-Module auf die Emulator-Hardware basiert. Solche VHDL-Module (=VHSIC Hardware Description Language, wobei VHSCI=Very High Speed Integrated Circuit) werden heute häufig zum Beschreiben komplizierter digitaler Systeme verwendet, wobei diese Hardware-Beschreibungssprache das gewünschte Verhalten einer Schaltung auf einer höheren Abstraktionsebene beschreibt, ohne mit einzelnen elektronischen Bauteilen zu arbeiten. Wiederum soll ohne Einschränken der Allgemeinheit im folgenden vorrangig von VHDL-Code oder VHDL-Modulen zur Erläuterung der Sensor-Emulatoren gesprochen werden, wobei die Erfindung nicht auf diese Art der Hardware-Beschreibung beschränkt ist.

Durch die genannte Portierung der VHDL-Module ist gewährleistet, dass die Verarbeitung im Emulator gleichwertig wie im Original bzgl. Reaktion, Timing und Laufzeit ist.

Die Eingangsgrößenverarbeitung kann ebenfalls größtenteils übernommen werden, insbesondere wenn es sich um Filterung sowie um eine signalverarbeitende Komponente handelt.

Somit muss lediglich eine für die Ankopplung des zu emulierenden Busteilnehmers (Sensor) an die Steuergeräteanordnung zuständige Verarbeitungsebene durch eine individuell nutzbare Verarbeitungsebene im Emulator ersetzt werden.

Das Gesagte veranschaulicht, dass der erfindungsgemäße Emulator die Eigenschaften des originalen Busteilnehmers übernimmt und aufgrund seiner individuell nutzbaren Verarbeitungsebene sowie weiterer individuell nutzbarer Komponenten mehr Möglichkeiten als der Originalbusteilnehmer besitzt. Insbesondere sind die Freiheitsgrade des Tests erhöht.

Der Emulator hat somit die Möglichkeit, beispielsweise über eigene Zwischenspeicher physikalische Eingangsgrößen gefiltert oder ungefiltert sowie Status- und Fehlerinformationen bereitzustellen, so dass auf dem Datenbus über eine definierte Zeitdauer (speichergrößen- und signalabhängig) ein beliebiges Verhalten des Originalbusteilnehmers nachgestellt werden kann.

Zusätzlich kann durch den Emulator in einer vorteilhaften Ausgestaltung ein oder alle Busteilnehmer gescannt und deren Verhalten erfasst werden. Bei dieser Funktion spricht man vom so genannten Horcher.

Einer der größten Vorteile des erfindungsgemäßen Vorgehens ist die Verwendung von möglichst vielen originalen Modulen (z.B. im VHDL-Code). Dies ermöglicht gegenüber den Kunden ein größtmögliches Vertrauen in die Tests und in die Verifikation der Steuergeräte.

Es zeigt sich als zweclanäßig, wenn der Emulator folgende Komponenten aufweist:
1. Leistungsfähiger FPGA (Field Programmable Gate Array); es handelt sich um einen frei programmierbaren Logikschaltkreis und somit um das Herz des Emulators;
2. gegebenenfalls EEPROM/Flashspeicher; hierbei handelt es sich um einen elektronisch löschbaren programmierbaren Speicherbaustein, bei dem jedes Byte einzeln bzw. Daten nur blockweise gelöscht und beschrieben werden können;
3. SD-RAM (Synchronous Dynamic Random Access Memory), als besondere Art eines Arbeitsspeichers; prinzipiell sind auch andere Arten von Arbeitsspeichern möglich;
4. unterschiedliche Bustransceiver zum Senden und Empfangen der Signale über den Datenbus, Ankopplung an den Buspegel und Pegelwandlung;
5. USB bzw. Firewire Cocontroller, hier als besondere Form einer Human Interface-Eingangs, beispielsweise von einem Steuer-PC in den Emulator;
6. ADConverter zur Wandlung analoger Signale in digitale, insbesondere wenn analoge Signale in den Emulator eingespeist werden sollen;
7. DAConverter, zur Wandlung digitaler Signale in analoge, insbesondere wenn das Steuergerät analoge Signale vom Emulator empfängt oder Testergebnisse in analoger Form ausgegeben werden sollen;
8. Timer, insbesondere wenn vom Emulator ein anderer Takt als der Systemtakt verwendet werden soll;
9. Digital I/O (z.B. Trigger) zur Initialisierung des Systems sowie zum Anhalten (Pause) oder Abbruch, auch hier handelt es sich um eine Art Human Interface.

Die Eingangsgrößen für die jeweiligen zu emulierenden Busteilnehmer können direkt in digitaler Form in den SD-RAM mit Hilfe der USB/Firewire-Schnittstelle übertragen werden. Sollte der Emulator auch als Scanner (Horcher) verwendet werden, können die Daten aus dem SD-RAM z.B. auf einen externen Rechner (PC) in umgekehrter Richtung übertragen werden. Des weiteren können Daten mit Hilfe des ADConverters kontinuierlich in den Emulator eingespeist werden. Somit ist die analoge oder digitale Einspeisung mittels der begleitenden Converter möglich. Dadurch wird im Emulator eine einfache Überwachung oder ein analoger Stimulus realisiert.

Durch die räumliche Trennung der emulierten Busteilnehmer und der hohen Datenübertragungsraten ist es in der Regel notwendig, eine Übertragungsstrecke mit LVDS (= Low Voltage Differential Signal) /LVDM (= Low Voltage Differential Multipoint-Treibern aufzubauen.

### Figuren

Anhand von in den Figuren dargestellten Ausführungsbeispielen soll die Erfindung und ihre Vorteile im folgenden näher erläutert werden.
- Figur 1: zeigt schematisch verschiedene Verarbeitungsebenen zur Eingangsgrö- ßenverarbeitung eines originalen Busteilnehmers,
- Figur 2: zeigt schematisch die verschiedenen Verarbeitungsebenen für die Ein- gangsgrößenverarbeitung eines Emulators, der den originalen Busteil- nehmer ersetzt und
- Figur 3: zeigt eine Ausführungsform eines erfindungsgemäßen Systems zum Tes- ten einer Steuergeräteanordnung.

### Bevorzugte Ausfühnmgsformen

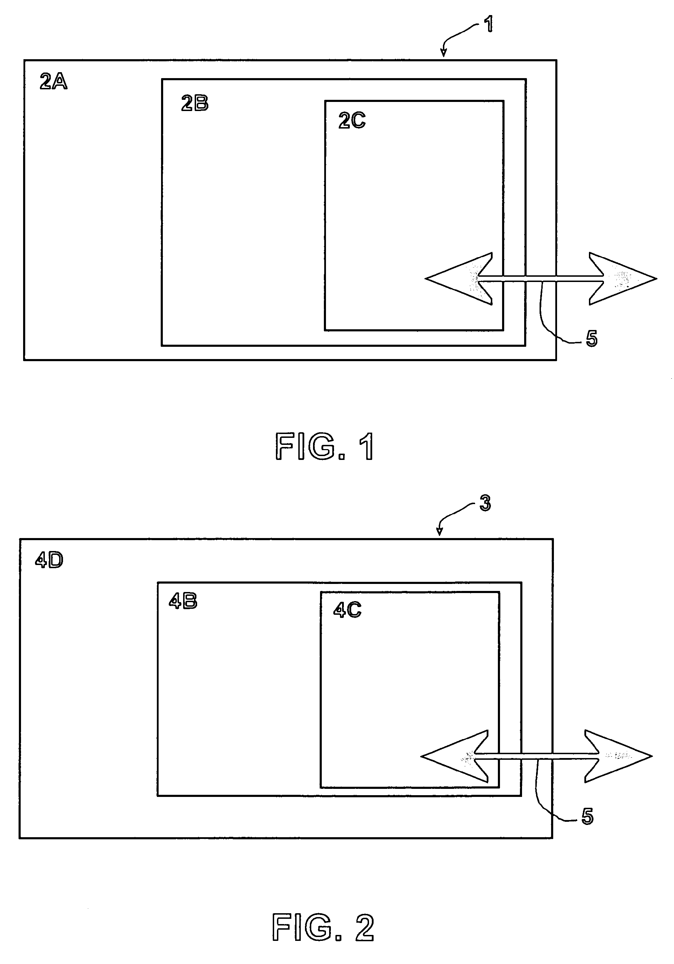

Figur 1 zeigt schematisch verschiedene Verarbeitungsebenen oder Layer 2A, 2B, 2C eines originalen Sensors 1, der stellvertretend für einen Busteilnehmer in einer Steuergeräteanordnung steht, die mindestens ein Steuergerät und mindestens einen solchen Sensor 1 aufweist. Steuergerät und Sensor sowie weitere Busteilnehmer sind über einen Datenbus über die Busverbindung 5 verbunden. solche Steuergeräteanordnungen finden typischerweise in Kraftfahrzeugen Verwendung, insbesondere um die eingangs beschriebenen Fahrzeugsysteme ESP, TCS, ABS zu realisieren.

Die Verarbeitungsebene 2A des Sensors 1 enthält im wesentlichen die zur Ankopplung an den Datenbus notwendigen Komponenten, wie Sensorkopfeingang, Sensorsignalaufbereitung und einen AD-Converter zur Wandlung der analogen Eingangssignale in digitale Signalfolgen. Für die folgende Signalverarbeitung sind die beiden Verarbeitungsebenen 2B und 2C verantwortlich. Die Verarbeitungsebene 2B umfasst ein Filtermodul, sowie Einheiten zur Einstellung eines Gain und eines Offsets sowie etwaige weitere Komponenten. Die Verarbeitungsebene 2C umfasst Offsetcontrol, Clipping, Statusregister, Errorregister, Serial number (SN), Statemaschine u. a. und ist damit insbesondere für die interne Signalumwandlung zuständig.

Die heute gängigste Form ist die Realisierung solcher Verarbeitungsebenen 2A, 2B, 2C in Form von modularen VHDL-Code.

Erfindungsgemäß wird zum Testen einer Steuergeräteanordnung ein oder mehrere Busteilnehmer durch entsprechende Emulatoren ersetzt. In diesem Ausfühnmgsbeispiel soll der Sensor 1 durch einen Sensor-Emulator 3 ersetzt werden. Wie bereits erwähnt können hierzu die meisten der relevanten Einheiten, nämlich insbesondere die Protokollerzeugung, Ausgangsgrößenverarbeitung und Logik/Steuerung basierend auf der Portierung der entsprechenden VHDL-Module auf die Emulator-Hardware vom Originalteilnehmer übernommen werden. Für die Emulierung der physikalischen Busankopplung und der Eingangsgrößenverarbeitung als weitere relevanten Einheiten sei auf Figur 2 verwiesen.

Figur 2 zeigt in der Darstellung der Figur 1 die entsprechenden Verarbeitungsebenen im Sensor-Emulator 3. Die Verarbeitungsebenen 4B und 4C entsprechen dabei den Verarbeitungsebenen 2B und 2C des originalen Sensors 1. Somit kann die Eingangsgrößenverarbeitung großteils übernommen werden. Die Emulatorhardware enthält die mit 4D gekennzeichnete individuell nutzbare Verarbeitungsebene, die die Eingangsgrößen sowie Status- und Fehlerinformationen für die Originalmodule in gleicher Art und Weise aufbereitet wie das originale Eingangsgrößenverarbeitungsmodul.

Die Verarbeitungsebene 4D, die die Verarbeitungsebene 2A des Sensors 1 ersetzt, umfasst beispielsweise folgende Komponenten:
drei Kanäle für analoge oder digitale 16-bit Signaleingänge (entsprechend den drei Fahrzeugachsen), einen RAM als Speicher, für jeden der genannten Kanäle einen Analogdigitalwandler (ADC) sowie einen Digitalanalogwandler (DAC), einen USB(Universal Serial Bus)-Anschluss für den Empfang von Daten beispielsweise eines Steuer-PCs, einen leistungsfähigen FPGA, wie zum Beispiel ein EPF10K50 oder größer, einen LVDS-Treiber für beispielsweise einen SPI- oder PAS-Bus sowie eventuell frei verwendbare UART (Universal Asynehronous Receiver/Transmitter) für Erweiterungen (CAN, ...).

Weitere geeignete Komponenten des Sensor-Emulators 3 können aus den weiter oben behandelten Komponenten 1. bis 9. gewählt werden.

Der Sensor-Emulator 3 hat die Möglichkeit, über eigene Zwischenspeicher physikalische Eingangsgrößen gefiltert oder ungefiltert sowie Status- und Fehlerinformationen bereitzustellen, so dass auf dem Bus über eine definierte Zeitdauer ein beliebiges Verhalten des Originalbusteilnehmers, wie dem Sensor 1, nachgestellt werden kann. Zusätzlich kann wie bereits erwähnt durch den Emulator 3 ein oder alle anderen Busteilnehmer gescannt und deren Verhalten erfasst werden.

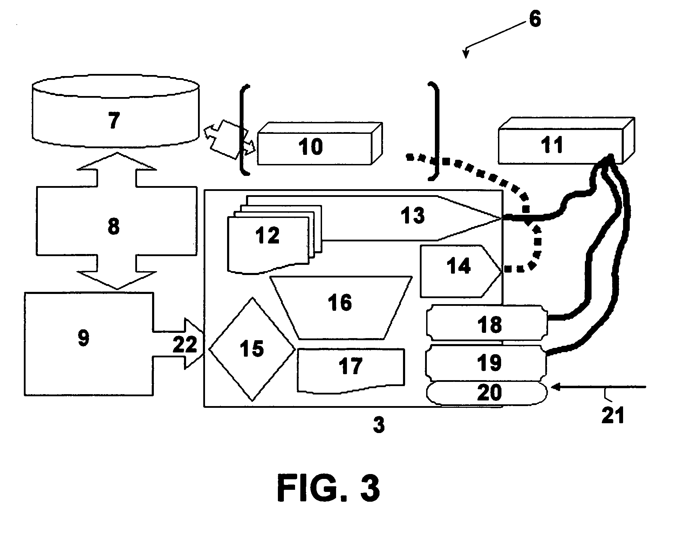

Ein konkretes Ausführungsbeispiel eines Systems 6 zum Testen einer Steuergeräteanordnung ist in Figur 3 schematisch dargestellt. Hierbei handelt es sich beispielsweise um den Fall der digitalen Crash-Einspeisung in der Airbag-Entwicklung.

Das Steuergerät (ECU) ist mit 11 bezeichnet. Mit dem vorhandenen Aufbau gemäß Figur 3 sollen die Eigenschaften des Steuergeräts 11, das beispielsweise Bestandteil eines Fahrzeugsystems ist, getestet werden. Hierzu werden dem Steuergerät 11 Testdaten, beispielsweise Sensortestdaten zugeführt. Diese Testdaten werden im Steuergerät 11 verarbeitet und entsprechende Signale werden vom Steuergerät 11 beispielsweise an nicht dargestellte Aktoren abgegeben.

In dem dargestellten beispielhaften Aufbau eines Testsystems 6 ist eine Datenbank 7, ein Vorverarbeitungsmodul 8 sowie ein Steuer-PC 9 vorhanden. Der Steuer-PC 9 kommuniziert über eine USB-Schnittstelle 22 mit dem USB 15 des Emulators 3. Bei dem Emulator 3 handelt es sich um einen Busteilnehmer der zu testenden Steuergeräteanordnung, insbesondere um einen Sensor-Emulator. Weiterhin kann ein Kurvengenerator 10 vorgesehen sein.

Die Komponenten des Emulators 3 wurden bereits oben ausführlich erläutert. Im folgenden kann daher die Aufzählung der Komponenten genügen: Neben dem USB (Universal Serial Bus) 15 ist ein RAM 12 mit beispielsweise 3 x 2 MB vorhanden. Entsprechend den drei Fahrzeugachsen sind drei Kanäle vorgesehen, wobei drei Digilalanalogkonverter (DAC) 13 sowie drei Analogdigitallconverter (ADC) 14 vorgesehen sind. Das FPGA ist mit 16 bezeichnet. Ein Latch 17 speichert interne Informationen wie Status, ID, Error, Nr,... Ein LVDS-Treiber 18 dient zum Anschluss an einen SPI-Bus, Transmitter und Receiver oder Transceiver 19 sind für einen PAS-Bus vorgesehen. Der Triggereingang ist mit 20 bezeichnet, das Triggersignal 21 wird in den Triggereingang 20 gespeist.

Zum Test des Steuergeräts 11 wird aus der Datenbank 7 eine geeignete Testroutine abgerufen. Diese gelangt über ein Vorverarbeitungsmodul 8 für Filtermodelle und die Signalvorverarbeitung in einem Steuer-PC 9, der für die Datenübertragung und Steuerinformationen verantwortlich ist. Die vom Steuer-PC 9 erzeugten Testsignale werden schließlich über eine USB-Schnittstelle 22 auf den entsprechenden Bus (USB) 15 im Emulator 3 gegeben.

Der Sensor-Emulator 3 nimmt nun exakt die gleiche Signalverarbeitung und -ausgabe vor wie der originale Sensor und gibt ein entsprechendes Signal in analoger oder digitaler Form an das Steuergerät 11 weiter.

Mittels dem in Figur 3 dargestellten Aufbau ist es auch möglich, analoge Signale von einem Kurvengenerator 10 als Testsignale zu erzeugen, die in den Analog-Digital-Konverter 14 des Emulators 3 eingespeist werden. Somit ist der dargestellte Emulator für das Einspeisen analoger und/oder digitaler Testsignale ausgelegt. Der eigentliche Testbeginn wird durch ein Triggersignal 21 ausgelöst, das an den Triggereingang 20 des Emulators 3 angelegt wird.

## Patentansprüche

1. System (6) zum Testen einer aus mindestens einem Steuergerät (11) und mindestens einem Sensor (1) bestehenden Steuergeräteanordnung, wobei Steuergerät (11) und Sensor (1) und etwaige weitere Busteilnehmer über einen Datenbus miteinander verbunden sind, und wobei zum Testen der Steuergeräteanordnung ein Testsignal in einen der Busteilnehmer eingespeist wird, wobei zumindest einer der Busteilnehmer durch einen entsprechenden Emulator (3) dieses Busteilnehmers ersetzt ist,
**dadurch gekennzeichnet, dass**
der Emulator (3) unterschiedliche Verarbeitungsebenen (4D, 4B, 4C) besitzt, und dass eine für die Ankopplung des zu emulierenden Busteilnehmer an die Steuergeräteanordnung zuständige Verarbeitungsebene (2A) durch eine individuell nutzbare Verarbeitungsebene (4D) im Emulator (3) ersetzt ist.

2. System nach Anspruch 1, **dadurch gekennzeichnet, dass** derjenige Busteilnehmer, in den das Testsignal einzuspeisen ist, durch seinen entsprechenden Emulator (3) ersetzt ist.

3. System nach Anspruch 2, **dadurch gekennzeichnet, dass** der emulierte Busteilnehmer ein Sensor (1) ist.

4. System nach einem der Ansprüche 1 bis 3, **dadurch gekennzeichnet, dass** der Emulator (3) eine Scannerfunktion beinhaltet, um Daten aus anderen Busteilnehmern zu erfassen.

5. System nach einem der Ansprüche 1 bis 4, **dadurch gekennzeichnet, dass** das System einen Rechner (9) für die Datenübertragung und Steuerinformationen aufweist, der eine Schnittstelle (22) zum Emulator (3) besitzt.

6. System nach einem der Ansprüche 1 bis 5, **dadurch gekennzeichnet, dass** der Emulator (3) für die Verarbeitung digitaler und/oder analoger Eingangsgrößen ausgebildet ist.

7. System nach einem der Ansprüche 1 bis 6, **dadurch gekennzeichnet, dass** der Emulator (3) für die Ausgabe digitaler und/oder analoger Ausgangsgrößen ausgebildet ist.

8. System nach einem der Ansprüche 1 bis 7, **dadurch gekennzeichnet, dass** die für die Signalverarbeitung und/oder -filterung zuständigen Verarbeitungsebenen (4B, 4C) mit denen des emulierten Busteilnehmers im wesentlichen übereinstimmen.

9. Verfahren zum Testen einer aus mindestens einem Steuergerät (11) und mindestens einem Sensor (1) bestehenden Steuergeräteanordnung, wobei Steuergerät (11) und Sensor (1) und etwaige weitere Busteilnehmer über einen Datenbus miteinander verbunden sind, und wobei zum Testen der Steuergeräteanordnung ein Testsignal in einen der Busteilnehmer eingespeist wird,
**dadurch gekennzeichnet, dass** der
Emulator (3) unterschiedliche Verarbeitungsebenen (4D, 4B, 4C) besitzt, und
dass eine für die Ankopplung des zu emulierenden Busteilnehmer an die Steuergeräteanordnung zuständige Verarbeitungsebene (2A) durch eine individuell nutzbare Verarbeitungsebene (4D) im Emulator (3) ersetzt ist.

10. Verfahren nach Anspruch 9, **dadurch gekennzeichnet, dass** derjenige Busteilnehmer in dem das Testsignal eingespeist wird, emuliert wird.

11. Verfahren nach Anspruch 10, **dadurch gekennzeichnet, dass** ein Sensor (1) der Steuergeräteanordnung emuliert wird.

12. Verfahren nach einem der Ansprüche 9 bis 11, **dadurch gekennzeichnet, dass** der Emulator (3) als Scanner verwendet wird, um Daten anderer Busteilnehmer zu erfassen.

13. Verfahren nach einem der Ansprüche 9 bis 12, **dadurch gekennzeichnet, dass** die Übertragung von Daten und von Steuerinformationen in den Emulator (3) über einen Rechner (9) vorgenommen wird.

14. Verfahren nach einem der Ansprüche 9 bis 13, **dadurch gekennzeichnet, dass** in den Emulator (3) digitale und/oder analoge Eingangsgrößen eingespeist werden.

15. Verfahren nach einem der Ansprüche 9 bis 14, **dadurch gekennzeichnet, dass** vom Emulator (3) digitale und/oder analoge Ausgangsgrößen ausgegeben werden.

## Claims

1. System (6) for testing a controller arrangement comprising at least one controller (11) and at least one sensor (1), wherein the controller (11) and the sensor (1) and any other bus subscribers are connected to one another by means of a data bus, and wherein the controller arrangement is tested by feeding a test signal into one of the bus subscribers, wherein at least one of the bus subscribers is replaced by an appropriate emulator (3) of this bus subscriber,
**characterized in that**
the emulator (3) has different processing levels (4D, 4B, 4C), and **in that** a processing level (2A) which is responsible for coupling the bus subscriber to be emulated to the controller arrangement is replaced by an individually usable processing level (4D) in the emulator (3).

2. System according to Claim 1, **characterized in that** the bus subscriber into which the test signal is to be fed is replaced by its appropriate emulator (3).

3. System according to Claim 2, **characterized in that** the emulated bus subscriber is a sensor (1).

4. System according to one of Claims 1 to 3, **characterized in that** the emulator (3) contains a scanner function in order to capture data from other bus subscribers.

5. System according to one of Claims 1 to 4, **characterized in that** the system has a computer (9) for the data transmission and control information, said computer having an interface (22) to the emulator (3).

6. System according to one of Claims 1 to 5, **characterized in that** the emulator (3) is designed for processing digital and/or analogue input variables.

7. System according to one of Claims 1 to 6, **characterized in that** the emulator (3) is designed for outputting digital and/or analogue output variables.

8. System according to one of Claims 1 to 7, **characterized in that** the processing levels (4B, 4C) which are responsible for the signal processing and/or filtering essentially match those of the emulated bus subscriber.

9. Method for testing a controller arrangement comprising at least one controller (11) and at least one sensor (1), wherein the controller (11) and the sensor (1) and any other bus subscribers are connected to one another by means of a data bus, and wherein the controller arrangement is tested by feeding a test signal into one of the bus subscribers,
**characterized in that**
the emulator (3) has different processing levels (4D, 4B, 4C), and **in that** a processing level (2A) which is responsible for coupling the bus subscriber to be emulated to the controller arrangement is replaced by an individually usable processing level (4D) in the emulator (3).

10. Method according to Claim 9, **characterized in that** the bus subscriber in which the test signal is fed in is emulated.

11. Method according to Claim 10, **characterized in that** a sensor (1) of the controller arrangement is emulated.

12. Method according to one of Claims 9 to 11, **characterized in that** the emulator (3) is used as a scanner in order to capture data from other bus subscribers.

13. Method according to one of Claims 9 to 12, **characterized in that** data and control information are transmitted to the emulator (3) via a computer (9).

14. Method according to one of Claims 9 to 13, **characterized in that** the emulator (3) has digital and/or analogue input variables fed into it.

15. Method according to one of Claims 9 to 14, **characterized in that** the emulator (3) outputs digital and/or analogue output variables.

## Revendications

1. Système (6) pour tester un ensemble d'appareil de commande constitué d'au moins un appareil de commande (11) et d'au moins un détecteur (1), l'appareil de commande (11), le détecteur (1) et d'éventuels autres participants au bus étant reliés les uns aux autres par un bus de données,
dans lequel, pour tester l'ensemble d'appareil de commande, on injecte un signal de test dans au moins un des participants au bus,
au moins un des participants au bus étant remplacé par un émulateur (3) approprié de ce participant au bus,
**caractérisé en ce que**
l'émulateur (3) présente différents niveaux de traitement (4D, 4B, 4C) et
**en ce qu'**un niveau de traitement (2A) responsable du couplage à l'ensemble d'appareil de commande du participant au bus à émuler est remplacé dans l'émulateur (3) par un niveau de traitement (4D) qui peut être utilisé séparément.

2. Système selon la revendication 1, **caractérisé en ce que** le participant au bus dans lequel le signal de test doit être injecté est remplacé par son émulateur (3) approprié.

3. Système selon la revendication 2, **caractérisé en ce que** le participant au bus émulé est un détecteur (1).

4. Système selon l'une des revendications 1 à 3, **caractérisé en ce que** l'émulateur (3) comporte une fonction de balayage qui permet de détecter des données provenant d'autres participants au bus.

5. Système selon l'une des revendications 1 à 4, **caractérisé en ce que** le système possède un calculateur (9) qui assure le transfert de données, qui présente des informations de commande et qui possède une interface (22) par rapport à l'émulateur (3).

6. Système selon l'une des revendications 1 à 5, **caractérisé en ce que** l'émulateur (3) est configuré pour le traitement de grandeurs d'entrée numériques et/ou de grandeurs d'entrée analogiques.

7. Système selon l'une des revendications 1 à 6, **caractérisé en ce que** l'émulateur (3) est configuré pour délivrer des grandeurs de sortie numériques et/ou des grandeurs de sortie analogiques.

8. Système selon l'une des revendications 1 à 7, **caractérisé en ce que** les niveaux de traitement (4B, 4C) responsables du traitement et/ou du filtrage des signaux correspondent essentiellement à ceux du participant au bus émulé.

9. Procédé pour tester un ensemble d'appareil de commande constitué d'au moins un appareil de commande (11) et d'au moins un détecteur (1), l'appareil de commande (11), le détecteur (1) et d'éventuels autres participants au bus étant reliés les uns aux autres par un bus de données,
dans lequel, pour tester l'ensemble d'appareil de commande, on injecte un signal de test dans au moins un des participants au bus, **caractérisé en ce que**
l'émulateur (3) présente différents niveaux de traitement (4D, 4B, 4C) et
**en ce qu'**un niveau de traitement (2A) responsable du couplage à l'ensemble d'appareil de commande du participant au bus à émuler est remplacé dans l'émulateur (3) par un niveau de traitement (4D) qui peut être utilisé séparément.

10. Procédé selon la revendication 9, **caractérisé en ce que** le participant au bus dans lequel le signal de test est injecté est émulé.

11. Procédé selon la revendication 10, **caractérisé en ce qu'**un détecteur (1) de l'ensemble d'appareil de commande est émulé.

12. Procédé selon l'une des revendications 9 à 11, **caractérisé en ce que** l'émulateur (3) est utilisé comme dispositif à balayage qui saisit les données d'autres participants au bus.

13. Procédé selon l'une des revendications 9 à 12, **caractérisé en ce que** la transmission de données et d'informations de commande dans l'émulateur (3) est réalisée par un ordinateur (9).

14. Procédé selon l'une des revendications 9 à 13, **caractérisé en ce que** des grandeurs d'entrée numériques et/ou des grandeurs d'entrée analogiques sont injectées dans l'émulateur (3).

15. Procédé selon l'une des revendications 9 à 14, **caractérisé en ce que** des grandeurs de sortie numériques et/ou des grandeurs de sortie analogiques sont délivrées par l'émulateur (3).
